# EUROPEAN PATENT SPECIFICATION

(11) **EP 1 141 104 B1**
(45) Date of publication and mention of the grant of the patent: **28.05.2003**
(21) Application number: 99961757.4
(22) Date of filing: 22.11.1999
(51) Int. Cl.: C08K 3/00, C09J 9/00

(54) **HEAT DEBONDABLE ADHESIVE COMPOSITION AND ADHESION STRUCTURE**
WÄRME ENTKLEBBARE KLEBSTOFFZUSAMMENSETZUNG UND KLEBESTRUKTUR
COMPOSITION ADHESIVE POUVANT SE DECOLLER A LA CHALEUR ET STRUCTURE ADHESIVE

(30) Priority: 08.01.1999 JP 277099
(43) Date of publication of application: 10.10.2001
(73) Proprietor: MINNESOTA MINING AND MANUFACTURING COMPANY, St. Paul, Minnesota 55133-3427 (US)
(72) Inventor: Kawate, Kohichiro, Machida-city Tokyo 194-0041 (JP); Kanki, Tetsuo, Matsudo-city Chiba 270 (JP)
(74) Representative: VOSSIUS & PARTNER
(86) International application number: US9927696
(87) International publication number: WO00040648

(56) References cited:
- EP-A- 0 453 912
- EP-A- 0 527 505
- EP-A- 0 612 823
- PATENT ABSTRACTS OF JAPAN vol. 018, no. 528 (C-1258), 6 October 1994 (1994-10-06) & JP 06 184504 A (NITTO DENKO CORP), 5 July 1994 (1994-07-05)

## Description

### Field ofthe Invention

The present invention relates to a heat debondable adhesive composition comprising a curable resin and a heat expandable material, wherein a heat expandable inorganic material is used as the heat expandable material. The present invention also relates to an adhesion structure using the heat debondable adhesive composition.

### Background of the Invention

Curing type adhesives comprising a curable resin, such as epoxy resin, and a curing agent for the resin have hitherto been used as adhesives for structures, such as adhesives for electrical and electronic parts and adhesives for parts and members of motor vehicles such as cars, aircrafts and vessels. The main reason is that curing type adhesives have both high adhesive strength and high heat resistance. However, in the case of conventional curing type adhesives, it is hardly possible to peel off the adhesive once bonded to articles (adherends), such as parts. Therefore, it was substantially impossible to reuse such articles (i.e., recycle articles). Also, it was substantially impossible to temporarily fix and protect articles, such as by using a protective sheet (a protective sheet is typically bonded to articles before use and is peeled off upon use).

Therefore, a debondable adhesive has been studied to make it possible to temporarily fix and protect articles. For example, Japanese Unexamined Patent Publication (Kokai) No. 6-184504 discloses a heat debondable adhesive comprising an adhesive component other than a thermosetting resin, such as pressure-sensitive adhesive, and heat expandable fine particles. As the heat expandable fine particles, those obtained by encapsulation of a gas foamable component, such as butane, propane, or pentane, are disclosed. When two articles are bonded using such a heat debondable adhesive and the adhesive is heated at a temperature higher than a boiling point of the gas foamable component, the heat expandable fine particles expand, making it possible to easily peel off the adhesive from the articles. The details of the mechanism of reduction, or elimination, of the peel strength are not made clear in the publication, but it is considered to be caused mainly by (i) increase in internal stress of the adhesive due to expansion of the heat expandable particles, and (ii) generation of a peel stress at the interface between the articles and the adhesive layer due to expansion of the surface of the adhesive layer. Since the boiling point of the gas foamable component is usually about 100°C, the adhesive can be peeled off by heat treatment at a comparatively low temperature.

Also known is a composition containing a heat expandable inorganic material capable of initiating expansion at a comparatively high temperature, unlike the organic material-based heat expandable particles described above. For example, Japanese Unexamined Patent Publication (Kokai) No. 6-57140 discloses a flame-retardant curable polyorganosiloxane composition comprising 2-40% by weight of hollow glass spheres having a predetermined outer diameter and 3-50% by weight of a heat expandable inorganic material capable of expanding at a temperature ranging from 80 to 250°C.
When such a polyorganosiloxane composition is used as an adhesive sealer for fireproof windows, a heat expandable inorganic material is added to the polyorganosiloxane composition for the purpose of improving the flame retardance. That is, such a polyorganosiloxane composition is used for the purpose of air-tight sealing of the gap between the window glass and window frame in case of fire, preventing or delaying fire flames and smoke from passing through the window. The polyorganosiloxane composition is not intended to have a heat debonding property like the adhesives described in Japanese Unexamined Patent Publication (Kokai) No. 6-184504.

Since the expansion initiation temperrture of the heat expandable fine particles is comparatively low in the case of the heat debondable adhesive, it is substantially difficult to use the adhesive at the expansion initiation temperature of the heat expandable fine particles. Accordingly, it is substantially impossible to enhance the heat resistance even when the curable resin is used as the adhesive component.

On the other hand, it is preferred that the article bonded with the layer of the heat debondable adhesive can be used after peeling off the layer of adhesive. However, prior literature disclosing a method of recycling such articles is not found at present.

### Summary of the Invention

A first aspect of the present invention is to provide a heat debondable adhesive composition that can easily enhance the heat resistance of the adhesive, and which can effectively reduce peel strength of the adhesive after a heat debonding treatment.

A second aspect of the present invention is to provide a novel adhesion structure comprising two articles and an adhesive layer with which the articles are bonded, wherein the articles can be reused after peeling off from the layer of the adhesive after a heat debonding treatment. That is, recycling of the articles can be performed.

According to the present invention, the first aspect described above can be attained by a heat debondable adhesive composition comprising a curable resin and a heat expandable material, wherein the heat expandable material is a heat expandable inorganic material.

According to the present invention, there is also provided a heat debondable adhesive composition comprising a curable resin and a heat expandable material, wherein expansion initiation temperature of the heat expandable material is not less than 150°C.

According to the present invention, there is also provided a heat debondable adhesive composition comprising a thermosetting resin and a heat expandable material, wherein expansion initiation temperature of the heat expandable material is higher than the curing temperature of the thermosetting resin.

According to the present invention, the second aspect described above can be attained by an adhesion structure comprising two articles and an adhesive layer with which the articles are bonded, wherein the adhesive layer is formed of the adhesive composition of the present invention and at least one of the articles becomes debondable at the interface between the articles and the adhesive layer at an expansion initiation temperature of the heat expandable inorganic material or higher.

### Detailed Description of the Preferred Embodiments

The present invention will be further described with reference to the preferred embodiments thereof.

### Heat Debondable Adhesive Composition

The heat debondable adhesive composition (hereinafter sometimes referred to as an "adhesive composition") of the present invention, as described above, comprises a curable resin and a heat expandable inorganic material as a heat expandable material. The details of the mechanism of reduction or elimination of the peel strength are not completely clear, similar to the case of the organic heat expandable particles described above, but it is considered to be caused mainly by (i) increase in internal stress of the adhesive due to expansion of the heat expandable particles, and (ii) generation of a peel stress at the interface between the articles and the adhesive layer due to expansion of the surface of the adhesive layer.

Note that the term "heat expandable material" used herein is defined to be material capable of increasing (expanding) its volume at a predetermined temperature (generally, the heat expansion initiation temperature) when temperature of the material is increased, resulting in variation of the volume of the material. The predetermined temperature at which the expansion is initiated (generally, heat expansion initiation temperature) is generally 150°C or more, preferably 200°C or more, and more preferably in the range of 250 to 500°C, although it is described hereinafter in detail. Further, the expansion rate of the material (ratio of the dimension of the expanded material to that of the unexpanded material, determined along the longitudinal expansion direction) is generally 1.1 or more, preferably 1.2 or more, and more preferably in the range of 1.3 to 30.

The reason why curable resin is used as the adhesive component is to enhance the heat resistance of the adhesive composition. Accordingly, the curable resin may be any of thermosetting, radiation curable (e.g., by ultraviolet ray, electron beam, etc.,) and moisture-curable types. Preferred are those that do not emit smoke and catch fire upon heat treatment. That is, those with flame retardance are preferred.

The heat treatment is preferably performed so as not to emit smoke and to catch fire. For example, the heat treatment is preferably performed by using microwave heating. To impart flame retardance to the adhesive composition, for example, a flame retarder (e.g., antimony pentaoxide or brominated epoxy resin) is added to the adhesive composition.

The reason why the heat expandable inorganic material is used in combination with the curable resin is that the heat expansion initiation temperature can be set to a higher temperature than in the case of conventional organic heat expandable particles. The heat expansion initiation temperature is usually not less than 150°C. To further enhance the heat resistance of the adhesive composition, the heat expansion initiation temperature of the heat expandable inorganic material is preferably not less than 200°C. When the heat expansion initiation temperature is too high, it may become difficult to carry out the heat debonding treatment (i.e., treatment for reducing the peel strength of the adhesive to the adherend by heating the adhesive to expand the heat expandable inorganic material). From these points of view, the heat expansion initiation temperature of the heat expandable inorganic material is preferably within a range of from 250 to 500°C.

The term "heat expansion initiation temperature" of the heat expandable inorganic material, as used herein, is the temperature at which the volume begins to increase (i.e., expand) when the temperature of the heat expandable inorganic material is raised from room temperature (i.e., about 25°C) at a heating rate of 15°C /min. and a change in volume of the heat expandable inorganic material is measurable. The heat expansion initiation temperature can be measured, for example, by using devices such as a heat expansion meter or TMA (thermal mechanical analyzer). Depending on the kind of heat expandable inorganic material, some heat expandable inorganic material begins to expand after the volume contracts. In that case, the temperature at which expansion starts is defined as the heat expansion initiation temperature.

When the curable resin comprises a thermosetting resin, the heat expansion initiation temperature of the heat expandable inorganic material is usually higher than that of a curing temperature of the thermosetting resin (i.e., the temperature at which the curable resin can be cured). That is, when the heat expansion initiation temperature of the heat expandable inorganic material is lower than the curing temperature of the thermosetting resin, the heat expandable inorganic material may expand during the thermosetting operation, thereby making it difficult to perform a bonding operation. From such a point of view, a difference between a curing temperature (H) of the thermosetting resin and a heat expansion initiation temperature (E) of the heat expandable inorganic material, that is, (E - H) is usually not less than 10°C, preferably not less than 20°C, and particularly preferably not less than 30°C.

The adhesive composition of the present invention can be prepared by dispersing the heat expandable inorganic material in the curable resin, substantially homogeneously. In the preparation of the adhesive composition, raw material components are usually mixed using a kneading device or a mixing device. For example, a kneader, roll mill, extruder, planetary mixer, or homomixer can be used. The raw material components are usually mixed at a temperature within a range from 20 to 130°C for a predetermined time within a range of from 10 minutes to 5 hours.

The adhesive composition of the present invention can contain components other than the curable resin and the heat expandable inorganic material as far as the effect of the present invention is not adversely affected. Additional components that can be used include, for example, curing agents for the curable resin, curing accelerators, radical initiators, organic fillers such as solid rubber particles, non-expandable inorganic fillers, coloring pigments, adhesive polymers, tackifiers, defoamers, and modifiers (e.g. silane couplers, etc.).

For the purpose of imparting thermal conductivity and electric conductivity, thermally conductive fillers or electrically conductive fillers can also be added. In the case where the adhesive composition contains thermally conductive filler (metal powder), the adhesive composition can be heated by dielectric heating or induction heating. In that case, damage of the article (e.g., adherend) caused by heating can be reduced.

It is also possible to use the adhesive composition as a thermosetting hot melt adhesive composition by adding a thermoplastic resin to the adhesive composition. The fluidity of the thermoplastic resin on heating is usually 1 g/10 min. or more in terms of a melt flow rate (hereinafter sometimes abbreviated to "MFR") measured at 190°C. Furthermore, "MFR" is a value measured in accordance with JIS (Japanese Industrial Standard) K 6760.

### Curable Resin

As the curable resin used in the present invention, for example, an epoxy resin is preferred. The epoxy resin imparts a thermosetting property to the adhesive composition in cooperation with a curing agent and/or a curing catalyst (accelerator). This allows the adhesive composition to easily exhibit high adhesion and high heat resistance after thermosetting and to easily peel from the interface between the adhesive layer and an article (adherend) after the heat debonding treatment.

The term "epoxy resin" used herein refers to a compound having at least one epoxy group in the molecule. The epoxy resin is preferably a monomer or oligomer having two or more glycidyl groups per one molecule thereof The epoxy resin may be one that is liquid at normal temperature or a solid. These epoxy resins can be used alone or in combination thereof. The epoxy equivalent of the epoxy resin is usually within a range from 150 to 1,000, and preferably from 170 to 500.

The epoxy resin that can be used in the present invention includes, for example, bisphenolic epoxy resin, phenol-novolak epoxy resin, cresol-novolak epoxy resin, aliphatic epoxy resin, and glycidyl methacrylate copolymer (e.g., ethylene-glycidyl methacrylate copolymer), but is not limited thereto.

The curing agent for thermosetting the epoxy resin is usually contained in a matrix phase. Since the curing agent dispersed in the matrix phase is solid at normal temperature, or separated from the matrix, the adhesive composition of the present invention has potentiality. The curing agent in the dispersion phase is usually in the form of particles and an average particle diameter is preferably from 1 to 100 µm, and particularly preferably from 5 to 50 µm. When the size of the dispersion phase is too small, the potentiality is liable to be lowered. On the other hand, when the size is too large, the thermosetting reaction may become ununiform, resulting in the reactivity being lowered.

The curing agent that can be used in the present invention includes, for example, dicyandiamide curing agents (including dicyandiamide and its derivative), organic acid hydazides, BF₃ complexes, imidazole derivatives, diaminomaleonitrile and its derivatives, and melamine and its derivatives.

To exhibit high adhesion performance, a dicyandiamide curing agent or organic acid hydrazides are preferred. Taking high potentiality and rapid curing property into consideration, the dicyandiamide curing agent is particularly preferred. The reason why the dicyandiamide curing agent displays such an excellent action is that the dicyandiamide curing agent is a so called "heat acceleration type" potential curing agent wherein it is contained as the dispersion phase at normal temperature without being dissolved in the epoxy resin, and is dissolved in the epoxy resin to rapidly start the reaction when heated to a melting point of the curing agent. Specific examples of the dicyandiamide derivative include "H3842 (product no.)" available from A.C.R. Co.

The content of the curing agent in the adhesive composition is preferably from 0.1 to 80 parts by weight, and particularly preferably from 1 to 50 parts by weight, based on 100 parts by weight of the epoxy resin. When the content is smaller than 0.1 parts by weight, the curing reaction of the epoxy resin is liable to become poor. On the other hand, when the content exceeds 80 parts by weight, unreacted curing agent is likely to remain in the thermoset article. The mechanical strength, moisture resistance and electrical characteristics of the thermoset article (adhesion composition after thermosetting) are lowered when unreacted curing agent is present.

For the purpose of lowering the curing temperature and the curing time, a curing accelerator can be used in combination with the curing agent. As a curing accelerator for dicyandiamide or a dicyandiamide derivative, for example, tertiary amine, imidazole or polyamine is preferred. Specific examples of the imidazole accelerator include "HX3088 (product no.)" available from Asahi Kasei Co., Ltd. The amount of the curing accelerator added should be appropriately decided according to the purposes, but is preferably from 0.1 to 20 parts by weight, and particularly preferably from 0.5 to 10 parts by weight. When the amount is smaller than 0.1 parts by weight, the acceleration effect is poor. On the other hand, when the amount exceeds 20 parts by weight, the potentiality is likely to become poor.

On the other hand, as the curable resin, for example, a thermosetting resin other than the above epoxy resin (e.g. urethane resin, acrylic resin, polyimide resin, bismaleimide resin, etc.) or an adhesive containing the same can also be used. A radiation-polymerizable resin can also be used. The radiation-polymerizable resin is a compound having one or more functional groups having a polymerizable unsaturated bond, such as (meth)acrylic group in the molecule. The radiation-polymerizable resin can also be used in combination with the epoxy resin. In this case, those capable of chemically reacting with the epoxy resin and/or curing agent can also be used.

Examples of the radiation-polymerizable resin include carboxyl group-containing acrylic monomer or oligomer such as acrylic acid and methacrylic acid, hydroxyl group-containing acrylic monomer or oligomer such as 2-hydroxy-3-phenoxypropyl acrylate, glycidyl group-containing acrylic monomer or oligomer such as glycidyl acrylate, glycidyl methacrylate and N-[4-(2,3-epoxypropoxy)-3,5-dimethylbenzyl]acrylamide, alkyl (meth)acrylate, N,N-dialkyl(meth)acrylamide, (moth)acryloylmorpholine, N-vinyl pyrrolidone and N-vinyl caprolactam. When using the radiation-polymerizable resin, a photopolymerization initiator is preferably used in combination.

### Heat Expandable Inorganic Material

The heat expandable inorganic material is not specifically limited as far as the effect of the present invention is not adversely affected. Examples thereof include inorganic materials such as dilated graphite, vermiculite, pearlite, mica, wermlandite, thanmasite and hydrotalcite. These inorganic materials may be used alone or in combination thereof.

The content of the heat expandable inorganic material in the adhesive composition is usually within a range of from 10 to 100 parts by weight, preferably from 20 to 80 parts by weight, and particularly preferably from 25 to 70 parts by weight, based on 100 parts by weight of the curable resin. When the content of the heat expandable inorganic material is too small, the peel strength reduction initiated by the heat debonding treatment may become insufficient and it may become difficult to peel the article from the adhesive. On the other hand, when the content is too large, the peel strength of the adhesive to the adherend (before heat debonding treatment) may be lowered and the mechanical strength of the adhesive composition after curing may be lowered. When the adhesive composition contains the curable resin, the curing agent and/or the curing accelerator, the content of the heat expandable inorganic material is usually adjusted so that the content is within the above-described range, based on 100 parts by weight of the curing resin, the curing agent and the curing accelerator in total.

### Recycling Method

The adhesive composition of the present invention can be used as an adhesive for recycling. An adhesion structure comprising an article bonded with an adhesive layer made of the adhesive composition of the present invention exerts the same adhesive strength as that of a conventional curing type adhesive as far as it is used at a temperature lower than the expansion temperature of the heat expandable inorganic material. When the heat debonding treatment is performed, the article can be easily peeled from the layer of the adhesive. Accordingly, the adhesive composition of the present invention can be used, most preferably, in a method of recycling the article wherein the article recovered by peeling off the adhesive layer is reused.

The preferred embodiment of the method of recycling the article using the adhesive composition of the present invention will now be described. First, an adhesion structure comprising two articles and an adhesive layer with which the articles are bonded, the adhesive layer being formed of a heat debondable adhesive composition, is prepared. As the article, for example, building materials, electrical and electronic parts, and parts and members for motor vehicles, such as cars, aircrafts, and vessels may be used.

Two articles can be bonded in the same manner as in the case of a conventional curing type adhesive. For example, an adhesive layer made of a heat debondable adhesive composition having a predetermined thickness is formed on one or both adherend surfaces of the above articles and then the adhesive layer is cured by heating or laminating the articles. If the curable resin is curable at a temperature even as low as room temperature, a heating operation may be unnecessary.

The adhesive layer can be formed by preparing an adhesive composition that is liquid before curing, applying the liquid composition at room temperature (i.e., about 20°C) using a conventional application means, and then solidifying the liquid composition. The liquid composition can be obtained by using a curable resin that is liquid at room temperature (e.g., liquid epoxy resin, etc.) or containing a volatile solvent in the adhesive composition.

Bonding can be completed by forming a film adhesive made of the adhesive composition of the present invention on a temporary substrate, such as liner, to form a laminate comprising a first article/a film adhesive/a second article; heating the laminate or press-bonding it at a temperature lower than room temperature; and curing the film adhesive. Using an adhesive sheet (or adhesive tape) comprising any one of the above articles as a backing, and a layer of an adhesive, the backing can also be bonded to the other article.

The thickness of the adhesive layer or film adhesive can be selected according to the purposes similar to the case of a conventional curing type adhesive. The thickness of the film adhesive is usually within a range of from 10 to 2,000 µm.

The adhesion structure prepared as described above can be treated in the same manner as that in an adhesion structure using a conventional adhesive. The heat debonding treatment may be performed when it becomes necessary to recover the article contained in the adhesion structure.

In the heat debonding treatment, the adhesive layer is heated so that the heat expandable inorganic material can expand, thereby reducing the peel strength between the adhesive layer and the article. In the case of heating, a conventional heating method can be used. For example, by bringing a heat source, such as heater, close to the adhesion structure, heat is applied to the adhesive layer. That is, the heat expandable inorganic material may be heated, for example, by convection, conduction or radiation.

It is also possible to apply heat by microwave heating, electromagnetic induction heating and dielectric heating. In the case of the microwave heating, for example, the above adhesion structure is disposed in a radiation chamber of a microwave radiation device, such as radar range, and the whole adhesion structure is exposed to microwaves. In the case of the microwave heating, the heat debonding treatment can be performed within a comparatively short time (e.g. 10-60 seconds) without causing thermal damage of the adherend.

After the heat debonding treatment, a peeling operation is performed so that peel arises from the interface between the article and the adhesive layer, and then the article is recovered. The peel strength after the heat debonding treatment varies depending on the material, size and configuration of the article, but is usually less than 20 kg/cm², preferably not more than 15 kg/cm², and particularly preferably not more than 10 kg/cm². When the peel strength after the heat debonding treatment is too large, the article may not be recoverable without causing breakage of the article. On the other hand, the peel strength (i.e., adhesive strength) before the heat debonding treatment is not specifically limited, but is usually not less than 20 kg/cm², and preferably from 30 to 1,000 kg/cm². Note that the peel strength is a shear peel strength measured at room temperature (i.e., about 20°C) at a tension speed of 50 mm/min.

The adhesive composition of the present invention can be used to bond electronic parts, for example, bonding of integrated circuit (IC) parts and printed circuit boards. In this case, when the electric parts are not recovered, the bonded parts can be used at a temperature lower than the heat expansion initiation temperature of the heat expandable inorganic material, substantially permanently, and the parts can be easily recovered, if necessary.

The adhesive composition of the present invention can also be used preferably to bond parts made of polymers such as fluoropolymers, polyamides, polyimides, polyether imides, polycarbonates, polyethylenes, polypropylenes, polyesters and epoxy resins to each other, or to bond polymer parts with parts made from other materials (e.g., fibers, metal, semiconductors of silicon, ceramic, glass, etc.). Specific examples of the metal include, for example, copper, iron, nickel, gold, silver, aluminum, tungsten, molybdenum and platinum.

When a metal layer is contained in the adhesion structure of the present invention, the heat debonding treatment can be performed by using dielectric heating. Specifically, dielectric heating can be used when any one of the articles contains a metal layer and/or an adhesive layer (adhesive layer with a three-layer structure comprising a first layer/a metal layer/a second adhesive layer) containing a metal layer therein. When the heat debonding treatment is performed by using dielectric heating, the thickness of the metal layer is usually within a range of from 5 to 200 µm.

### Examples

The present invention will be described with reference to examples thereof. The "peel strength" described in the examples is a shear peel strength measured at room temperature (i.e., about 20°C) at a tension speed of 50 mm/min.

### Example 1

70 parts by weight of an epoxy adhesive (epoxy adhesive manufactured by Sumitomo 3M Co., Ltd., "product no.: DP-125) and 30 parts by weight of vermiculite were mixed using a mixing device, thereby dispersing vermiculite into the epoxy adhesive until the mixture became generally homogeneous. The heat expansion initiation temperature of vermiculite, measured using a heat expansion meter, was about 400°C.

Using the adhesive composition of this example, two polycarbonate plates with a size of 100 mm (length) x 25 mm (width) x 2 mm (thickness) were bonded. The area (mileage) of the adhesive layer made of the adhesive composition was 25 mm x 25 mm and the layer thickness was about 30 µm. After bonding, curing was completed by standing the plates at room temperature (i.e., about 25°C) for 3 days to obtain an adhesion structure of this example.

The resulting adhesion structure was put in a radar range (manufactured by Hitachi Corp., "product no.: MR-33"), exposed to a heat debonding treatment by microwave heating for 30 seconds, and then removed from the range. After the adhesion structure was allowed to stand for three hours, the peel strength at the interface between the polycarbonate plate and the adhesive layer was measured. As a result, it was 5 kg/cm².

On the other hand, the peel strength of the adhesion structure of this example, which was not exposed to the heat debonding treatment, was measured in the same manner as in described above. It was 49 kg/cm².

### Example 2 (Comparative Example)

In the same manner as that in Example 1, except for using only the above epoxy adhesive in the adhesive layer, an adhesion structure of this example was obtained. This adhesion structure was also exposed to the heat debonding treatment in the same manner as that in Example 1, and the peel strength at the interface between the polycarbonate plate and the adhesive layer was measured. It was 55 kg/cm². On the other hand, the peel strength of the adhesion structure of this example, which was not exposed to the heat debonding treatment, was also 55 kg/cm².

As described above, according to the present invention, by using the heat expandable inorganic material in combination with the curable resin, the heat resistance of the resulting adhesive composition can be enhanced and, at the same time, the peel strength after the heat treatment can be effectively reduced. Furthermore, when two articles are bonded by using such an adhesive composition, the articles can be reused after peeling the layer of the adhesive from the article using a heat debonding treatment. The range of recycling of the articles is wide and the articles include, for example, building materials, electrical and electronic parts, motor vehicles, and other parts and members.

## Claims

1. A heat debondable adhesive composition comprising a curable epoxy resin and a heat expandable material selected from dilated graphite, vermiculite, pearlite, mica, wermlandite, thanmasite, hydrotalcite, and mixtures thereof.

2. A heat debondable adhesive composition according to claim 1, wherein expansion initiation temperature of the heat expandable material is not less than 150°C.

3. A heat debondable adhesive composition according to claim 1, wherein expansion initiation temperature of the heat expandable material is higher than a curing temperature of the curable epoxy resin.

4. A heat debondable adhesive composition according to claim 1, wherein the heat expandable inorganic material comprises 10 to 100 parts by weight based on 100 parts by weight of the curable epoxy resin.

5. A heat debondable adhesive composition according to claim 1, further comprising a curing agent for the curable epoxy resin.

6. A heat debondable adhesive composition according to claim 5, further comprising a curing accelerator.

7. A heat debondable adhesive composition according to claim 1, wherein the curable epoxy resin comprises a radiation-polymerizable resin.

8. An adhesion structure comprising two articles and an adhesive layer with which the articles are bonded, wherein the adhesive layer is formed of the adhesive composition of claim 1 and at least one of the articles becomes debondable at the interface between the articles and the adhesive layer at an expansion initiation temperature of the heat expandable material or higher.

9. The adhesion structure of claim 8, wherein at least one of the articles is reusable after debonding at the expansion initiation temperature of the heat expandable material contained in the adhesive composition.

10. A method of bonding at least two articles, the method comprising:
bonding an adhesion structure comprising two articles and an adhesive layer, wherein the adhesive layer comprises the heat debondable adhesive composition of claim 1.

11. A method of debonding the at least two articles bonded according to claim 10, the method comprising:
heating the adhesive layer so that the heat expandable material in the heat debondable adhesive composition can expand; and
peeling the adhesive layer from at least one article.

12. The method of claim 11, wherein peel strength of the adhesive layer upon peeling the adhesive layer from the at least one article is less than 20 kg/cm².

13. A reusable article recycled according to the method of claim 11.

## Patentansprüche

1. Wärmeablösbare Klebstoffzusammensetzung, umfassend ein härtbares Epoxy-Harz und eine wärmedehnbare Substanz, ausgewählt aus expandiertem Graphit, Vermiculit, Perlit, Glimmer, Wermlandit, Thanmasit, Hydrotalkit und Gemischen davon.

2. Wärmeablösbare Klebstoffzusammensetzung gemäß Anspruch 1, wobei die Initiierungstemperatur der Ausdehnung der wärmedehnbaren Substanz nicht weniger als 150°C beträgt.

3. Wärmeablösbare Klebstoffzusammensetzung gemäß Anspruch 1, wobei die Initiierungstemperatur der Ausdehnung der wärmedehnbaren Substanz höher als die Härtungstemperatur des härtbaren Epoxy-Harzes ist.

4. Wärmeablösbare Klebstoffzusammensetzung gemäß Anspruch 1, wobei die wärmedehnbare, anorganische Substanz 10 bis 100 Gewichtsteile, bezogen auf 100 Gewichtsteile des härtbaren Epoxy-Harzes, umfasst.

5. Wärmeablösbare Klebstoffzusammensetzung gemäß Anspruch 1, weiter urnfassend ein Härtungsmittel für das härtbare Epoxy-Harz:

6. Wärmeablösbare Klebstoffzusammensetzung gemäß Anspruch 5, weiter umfassend einen Härtungsbeschleuniger.

7. Wärmeablösbare Klebstoffzusammensetzung gemäß Anspruch 1, wobei das härtbare Epoxy-Harz ein strahlungspolymerisierbares Harz umfasst.

8. Klebestruktur, umfassend zwei Gegenstände und eine Klebstoffschicht, mit welcher die Gegenstände verbunden sind, wobei die Klebstoffschicht aus der Klebstoffzusammensetzung nach Anspruch 1 gebildet ist und mindestens einer der Gegenstände an der Grenzfläche zwischen den Gegenständen und der Klebstoffschicht bei einer Initiierungstemperatur der Ausdehnung der wärmedehnbaren Substanz oder höher ablösbar wird.

9. Klebestruktur nach Anspruch 8, wobei mindestens einer der Gegenstände nach dem Entkleben bei einer Initiierungstemperatur der Ausdehnung der in der Klebstoffzusammensetzung enthaltenen wärmedehnbaren Substanz wiederverwendbar ist.

10. Verfahren zum Verbinden von mindestens zwei Gegenständen, wobei das Verfahren das Binden einer Klebestruktur, umfassend zwei Gegenstände und eine Klebstoffschicht, umfasst, wobei die Klebstoffschicht die wärmeablösbare Klebstoffzusammensetzung nach Anspruch 1 umfasst.

11. Verfahren zum Entkleben von mindestens zwei gemäß Anspruch 10 verbundenen Gegenständen, wobei das Verfahren
das Erwärmen der Klebstoffschicht, so dass sich die wärmedehnbare Substanz in der wärmeablösbaren Klebstoffzusammensetzung dehnen kann, und
Abziehen der Klebstoffschicht von mindestens einem Gegenstand umfasst.

12. Verfahren nach Anspruch 11, wobei die Abziehfestigkeit der Klebstoffschicht beim Abziehen der Klebstoffschicht von mindestens einem Gegenstand weniger als 20 kg/cm² beträgt.

13. Wiederverwendbarer, gemäß dem Verfahren nach Anspruch 11 rückgeführter Gegenstand.

## Revendications

1. Composition adhésive pouvant se décoller à la chaleur comprenant une résine époxy vulcanisable et une matière thermodilatable choisie parmi le graphite dilaté, la vermiculite, la perlite, le mica, la wermlandite, la thanmasite, l'hydrotalcite et leurs mélanges.

2. Composition adhésive pouvant se décoller à la chaleur selon la revendication 1, dans laquelle la température d'initiation de dilatation de la matière thermodilatable n'est pas inférieure à 150° C.

3. Composition adhésive pouvant se décoller à la chaleur selon la revendication 1, dans laquelle la température d'initiation de dilatation de la matière thermodilatable est supérieure à une température de vulcanisation de la résine époxy réticulable.

4. Composition adhésive pouvant se décoller à la chaleur selon la revendication 1, dans laquelle la matière inorganique thermodilatable comprend de 10 à 100 parties en poids sur la base de 100 parties en poids de la résine époxy réticulable.

5. Composition adhésive pouvant se décoller à la chaleur selon la revendication 1, comprenant en outre un agent de réticulation pour la résine époxy réticulable.

6. Composition adhésive pouvant se décoller à la chaleur selon la revendication 5, comprenant en outre un accélérateur de réticulation.

7. Composition adhésive pouvant se décoller à la chaleur selon la revendication 1, dans laquelle la résine époxy réticulable comprend ùne résine polymérisable par rayonnement.

8. Structure adhésive comprenant deux articles et une couche adhésive avec laquelle les articles sont collés, dans laquelle la couche adhésive est constituée de la composition adhésive de la revendication 1 et au moins l'un des articles devient décollable à l'interface entre les articles et la couche adhésive à une température d'initiation de dilatation de la matière thermodilatable ou supérieure.

9. Structure adhésive selon la revendication 8, dans laquelle au moins l'un des articles est réutilisable après le décollage à la température d'initiation de dilatation de la matière thermodilatable contenue dans la composition adhésive.

10. Procédé de décollage d'au moins deux articles, le procédé consistant à :
coller une structure adhésive comprenant deux articles et une couche adhésive, dans laquelle la couche adhésive comprend la composition adhésive pouvant se décoller à la chaleur de la revendication 1.

11. Procédé de décollage d'au moins deux articles collés selon la revendication 10, le procédé consistant à :
chauffer la couche adhésive de sorte que la matière thermodilatable dans la composition adhésive pouvant se décoller à la chaleur puisse se dilater ; et
arracher la couche adhésive d'au moins un article.

12. Procédé selon la revendication 11, dans lequel la résistance à l'arrachement de la couche adhésive lors de l'arrachement de la couche adhésive d'au moins un article est inférieure à 20 kg/cm².

13. Article réutilisable recyclé selon le procédé de la revendication 11.
